# EUROPEAN PATENT APPLICATION

(11) **EP 2 530 833 A2**
(43) Date of publication of application: **05.12.2012**
(21) Application number: 12163913.2
(22) Date of filing: 12.04.2012
(51) Int. Cl.: H03F 1/56, H03F 3/193, H03F 3/24, H03F 3/60, H03F 3/72

(54) **RF amplifier with open circuit output off-state**

(30) Priority: 31.05.2011 US 201113149640
(71) Applicant: Raytheon Company, Waltham, MA 02451-1449 (US)
(72) Inventor: Fast, Bryan, Texas, TX 75040 (US)
(74) Representative: Müller, Wolfram Hubertus

(57) **Abstract**

A method of operating an amplifier output of an amplifier as a signal switch, the method including coupling a gate of a switch transistor (102) of the amplifier to a switch signal line, coupling a gate of an amplifier transistor (101) of the amplifier to a gate signal line, and controlling impedance of the amplifier by manipulating gate bias voltages of the transistors (101, 102) via the signal lines.

## Description

This invention was made with U.S. Government support. The U.S. Government has certain rights in this invention. We will not identify the source of funding, at the customer's request.

### BACKGROUND

The present invention relates to the field of amplifiers.

Transmit/receive (TR) chips require a switch network to implement bidirectional operation. The loss of this switch network during operation directly effects the noise performance of the amplifier and contributes to the degradation of wireless system range.

A TR system may include a 3-port "Y-junction" circulator for low-loss/high-power applications that is coupled at a first port to an antenna element/array, at a second port to the input of a receive amplifier, and at a third port to the output of a transmit amplifier. The output of the receive amplifier and the input of the transmit amplifier may be coupled to a single pole, double throw static switch, and may be alternately coupled to the antenna and the remainder of the TR system via operation of the switch and the circulator. Accordingly, when the system is operating in a receive mode, the circulator and the switch electrically couple the antenna to the remainder of the TR system through the receive amplifier, while also causing the electrical path through the transmit amplifier to be electrically isolated, or decoupled, from the antenna and the remainder of the TR system, thereby enabling a receive signal received by the antenna to be sent to the system processor of the TR system. Similarly, when the TR system is operating in a transmit mode, the circulator and switch electrically decouple the receive amplifier while electrically coupling the antenna to the rest of the TR system via the transmit amplifier, thereby enabling a transmit signal to be sent by the system processor to be radiated by the antenna.

### SUMMARY

Embodiments of the present invention operate an amplifier, such as that of a TR system or other electrical system, by enabling the output matching network of the amplifier to operate as half of a single pole, double throw switch when it is in the off state. By employing the transistor from the amplifier, a simple change in the bias voltage of the transistor makes the transistor perform as an RF switch. Accordingly, the need for separate switch circuitry or circulator circuitry coupled to the amplifier is eliminated.

By operating an amplifier of a TR system as a switch in the absence of a switch or circulator, the number of tuning elements required to operate the TR system may be reduced, while the loss of the TR system may be reduced by nearly the amount of loss that would otherwise be caused by such switch circuitry or circulator circuitry. Furthermore, the amount of space consumed by the TR system and the cost to manufacture the TR system may also be reduced.

Accordingly, by controlling the bias voltage of the amplifiers in a TR system to operate the amplifiers as signal switches, the receive amplifier may act as a low-noise amplifier during a receive mode, while the transmit path through the transmit amplifier effectively acts as an "open" circuit, whereby no signal passes therethrough. While in a transmit mode, however, the transmit amplifier may act as a high-power amplifier, while no signal passes through the receive amplifier or receive path.

One embodiment of the present invention provides a method of operating an amplifier output of an amplifier as a signal switch, the method including coupling a gate of a switch transistor of the amplifier to a switch signal line, coupling a gate of an amplifier transistor of the amplifier to a gate signal line, and controlling impedance of the amplifier by manipulating gate bias voltages of the transistors via the signal lines.

Controlling impedance of the amplifier may include enabling an electrical signal to pass through the amplifier in an on mode, and preventing an electrical signal from passing through the amplifier in an off mode.

The method may further include coupling the signal lines to a system processor and coupling a drain of the amplifier transistor to the system processor, and manipulating gate bias voltages of the transistors may include delivering a control signal to the switch signal line, and manipulating a drain voltage of the drain.

The method may further include operating tuning elements of the amplifier as one or more quarter-wave shunt switches.

Controlling impedance of the amplifier may include operating tuning elements of the amplifier.

The method may further include coupling the gate signal line to an electrode of the switch transistor, and manipulating gate bias voltages of the transistors may include delivering a control signal to the switch signal line and manipulating a drain voltage of the amplifier transistor.

The method may further include coupling the gate signal line to an electrode of the switch transistor, and delivering a control signal to the switch signal line may couple the gate signal line to a ground.

The amplifier may be a transmit amplifier, the switch transistor may be a transmit switch transistor, the amplifier transistor may be a transmit amplifier transistor, the switch signal line may be a transmit switch signal line, and the gate signal line may be a transmit gate signal line, and the method may further include coupling a gate of a receive switch transistor of a receive amplifier to a receive switch signal line, coupling a gate of a receive amplifier transistor of the receive amplifier to a receive gate signal line, coupling the output of the receive amplifier to a system processor, coupling an input of the transmit amplifier to the output of the receive amplifier, coupling an input of the receive amplifier to an antenna, coupling the output of the transmit amplifier to the input of the receive amplifier, coupling the switch signal lines to the system processor, and controlling impedances of the amplifiers by manipulating gate bias voltages of the transistors via the signal lines.

The method may further include designing switch network parasitics of the receive and transmit amplifiers to match the receive and transmit amplifiers.

Coupling the output of the transmit amplifier to the input of the receive amplifier may include directly coupling the output of the transmit amplifier to the input of the receive amplifier.

Coupling an input of the transmit amplifier to the output of the receive amplifier may include directly coupling an input of the transmit amplifier to the output of the receive amplifier.

The method may further include coupling the receive gate signal line to an electrode of the receive switch transistor, and coupling the transmit gate signal line to an electrode of the transmit switch transistor.

Manipulating gate bias voltages of the transistors may include delivering TR control signals from the system processor to the switch signal lines.

The method may further include coupling the gate signal lines to the system processor and coupling drains of the amplifier transistors to the system processor, and manipulating gate bias voltages of the transistors may include manipulating drain voltages of the amplifier transistors.

The method may further include operating tuning elements of the amplifiers to further control impedance of the amplifiers.

The method may further include operating the receive amplifier with nominal impedance and the transmit amplifier as an open-circuit during a receive mode, detecting a receive signal with the antenna, and delivering the receive signal detected by the antenna to the system processor during the receive mode.

The method may further include operating the receive amplifier as an open-circuit and the transmit amplifier with nominal impedance during a transmit mode, delivering a transmit signal to the antenna from the system processor during the transmit mode, and radiating the transmit signal delivered to the antenna.

Accordingly, embodiments of the present invention enable an amplifier to be operated as a switch. Embodiments of the present invention also enable a TR system to be operated in the absence of switch or circulator circuitry, thereby improving performance of the TR system, while also reducing the size and the cost of manufacture of the TR system.

### BRIEF DESCRIPTION OF THE DRAWINGS

The accompanying drawings, together with the specification, illustrate exemplary embodiments of the present invention, and, together with the description, serve to explain aspects of embodiments of the present invention. The above and other features and aspects of the present invention will become more apparent by describing in detail exemplary embodiments thereof with reference to the attached drawings, in which:
FIG. 1 is a circuit diagram of a TR system including transmit and receive amplifiers operated according to an embodiment of the present invention;
FIG. 2 is a circuit diagram depicting a combination of a switch and an amplifier output;
FIG. 3 is a circuit diagram depicting an amplifier output of an amplifier operated according to an embodiment of the present invention; and
FIG. 4 is a circuit diagram depicting a method of bias modification for implementing a TR system according to an embodiment of the present invention.

### DETAILED DESCRIPTION

Embodiments of the present invention eliminate the need for switch or circulator circuitry during operation of an electrical system utilizing amplifiers, such as a TR antenna system, by controlling transistors of one or more amplifiers. By manipulating bias voltages of the transistors of the amplifier, embodiments of the present invention cause the amplifier to perform as a switch, such as an RF switch.

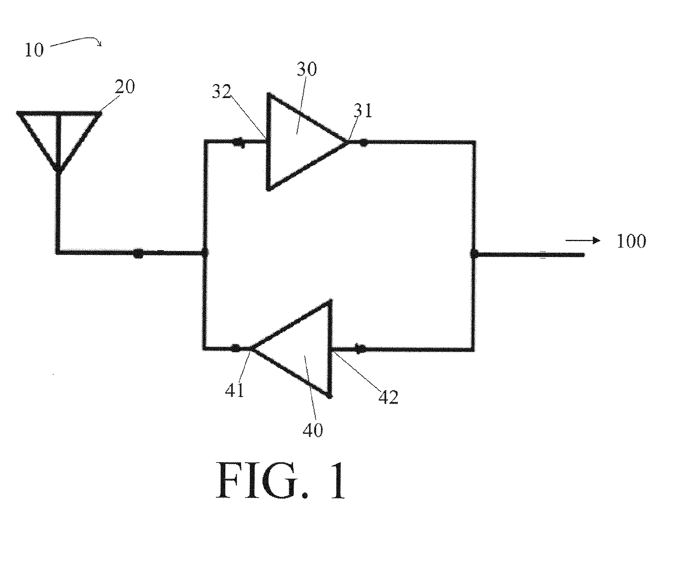

Referring to FIG. 1, a TR system 10 operated according to an embodiment of the present invention includes an antenna element 20 coupled to both an input 32 of a receive amplifier 30, and an output 41 of a transmit amplifier 40. Although a single antenna element 20 is shown, the antenna element 20 may also represent a plurality of antennas or antenna elements, as in an antenna array. An output 31 of the receive amplifier 30, and an input 42 of the transmit amplifier 40 are coupled to each other and to the remainder of the TR system 10 including a system processor 100, the details of which are not shown and will be known to one of ordinary skill in the art. Furthermore, the two amplifiers 30, 40 may be operated as a single TR MMIC component.

The receive amplifier 30 may be operated as a low-noise amplifier (LNA) while the TR system 10 is in a receive mode. While in the receive mode, the impedance of the transmit path may be controlled by manipulating bias voltages of transistors of the transmit amplifier 40 using the system processor 100, and the impedance of the transmit path may be made high so that the transmit amplifier 40 operates as if it was an "open" circuit. When the TR system 10 of the present embodiment is operated in a transmit mode, the transmit amplifier 40 may be operated as a high-power amplifier. While in the transmit mode, the impedance of the receive path through the receive amplifier 30 may also be made high so that the receive amplifier 30 operates as if it was an "open" circuit.

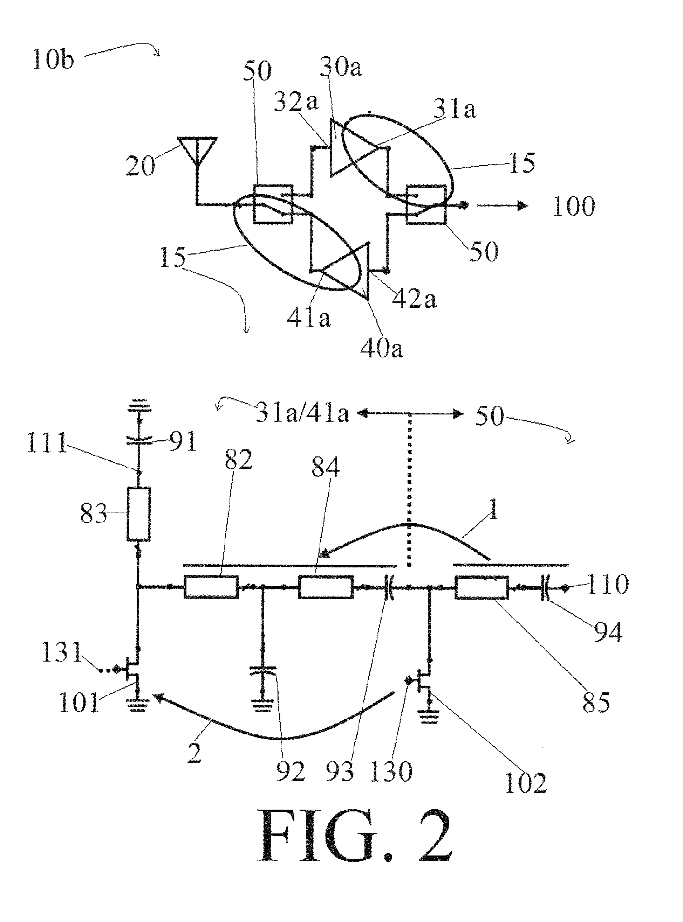

FIG. 2 depicts the operation of a TR system 10b, wherein the circuitry of the output 31a, 41a of either the receive amplifier 30a or the transmit amplifier 40a is shown in combination with the circuitry of the single pole, double throw static switch 50 coupled thereto. The combination of the output 31a, 41a (shown on the left) with the switch 50 (shown on the right) is indicated by reference character 15. The combination 15 includes tuning elements 82, 83, 84, and 85, capacitors 91, 92, 93, and 94, an amplifier transistor 101, and a switch transistor 102, wherein the transistors 101 and 102 may be field-effect transistors (FETs). The switch transistor 102 of the switch 50 may receive a signal, such as a TR control signal, from a TR state line 130, or switch signal line 130, to thereby operate the switch 50 and switch the TR system 10b between the receive and transmit modes. The various tuning elements 82, 83, 84, and 85 may be controlled via transmission lines, with tuning element 85 capable of being operated as a quarter-wave shunt switch 85.

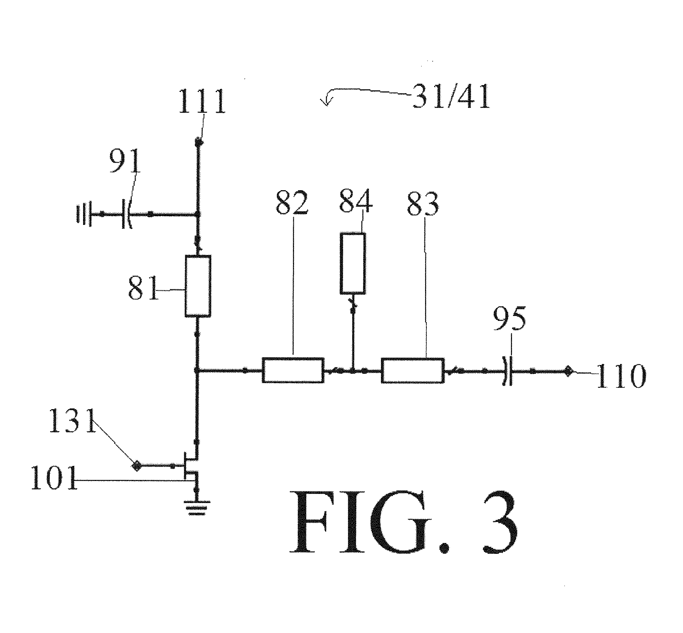

The arrows 1 and 2 shown in FIG. 2 depict how the functions of the various indicated elements of the TR system 10b may be achieved by the outputs 31, 41 of the amplifiers 30, 40 operated according to an embodiment of the present invention, as depicted by FIG. 3. For example, arrow 2 depicts that the functions of transistors 101 and 102 of the amplifier 30a, 40a of FIG. 2 may be achieved by the amplifier transistor 101 of the amplifier 30, 40, which is operated according to the embodiment depicted in FIG. 3.

FIG. 3 depicts the output 31, 41 of either the receive amplifier 30 or the transmit amplifier 40, which may be operated according to an embodiment of the present invention. Referring to FIG. 3, the output 31, 41 of the amplifier 30, 40 includes tuning elements 81, 82, 83, and 84, wherein harmonic tuning of the amplifier 30, 40 may be achieved using tuning elements 81 and 84. Furthermore, the tuning elements 82, 83, and 84 may be operated as a quarter-wave shunt switch. The output 31, 41 also includes capacitors 91 and 95, wherein capacitor 95 may achieve the operation of the combination of capacitors 93 and 94 shown in FIG. 2. The output 31, 41 also includes amplifier transistor 101 that may be manipulated along with a drain voltage 111 and the tuning elements 81, 82, 83, and 84 to control the impedance of the amplifier output 31, 41. Furthermore, the amplifier transistor 101 may be an FET, although the present invention is not limited thereto.

Viewing the output 31, 41 of FIG. 3 as the output 31 of the receive amplifier 30, when the receive amplifier 30 is operational, and the TR system 10 is operating in the receive mode, the impedance of line 110 is a nominal impedance, such as, for example, 50 ohms. When the TR system 10 is operating in the transmit mode, the impedance of line 110 is high, e.g., an "open-circuit" impedance, and electrical signals along the receive path are effectively blocked by the receive amplifier 30.

Similarly, when the TR system 10 is operated in a transmit mode, and the transmit amplifier 40 is operational, the impedance of line 110 of the transmit amplifier 40 is a nominal impedance, allowing an electrical signal to pass therethrough. When the TR system 10 is operated in a receive mode, the impedance of line 110 of the transmit amplifier 40 is high, and electrical signals along the transmit path are effectively blocked by the transmit amplifier 40.

The amplifier transistor 101 may be operated by delivering a gate signal from a system processor 100 to the gate of the amplifier transistor 101 via a gate signal line 131, and by also manipulating the drain voltage of line 111 by operation of the system processor 100. In some embodiments of the present invention, the gate signal delivered to the gate of the amplifier transistor 101 may depend on the operation of the switch transistor 102, shown in FIG. 2. By manipulating the gate bias voltage of the amplifier transistor 101 of FIG. 3, the functions of transistors 101 and 102 of FIG. 2 may be combined, and the amplifier transistor 101 may be operated as an RF switch. Furthermore, harmonic tuning may be achieved by harmonically tuning the tuning elements 81 and 84 via transmission lines.

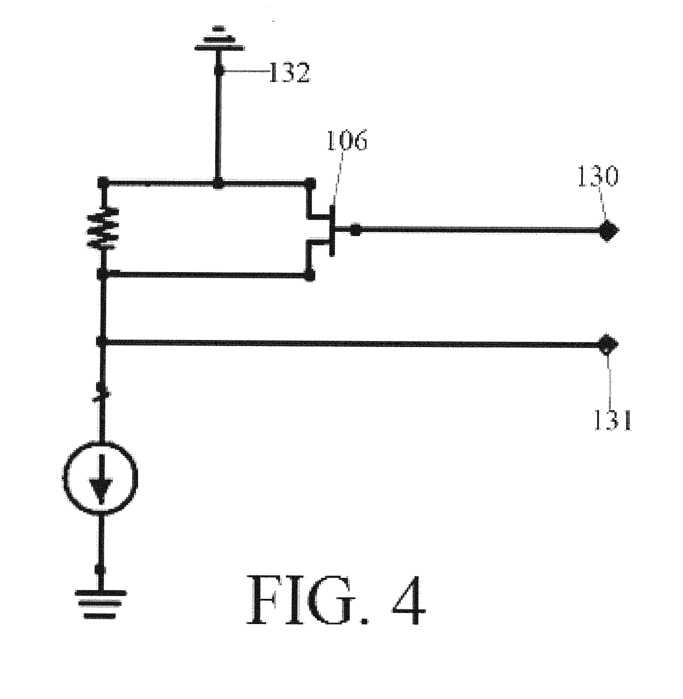

FIG. 4 depicts a method of bias modification of an amplifier 30, 40 according to an embodiment of the present invention. The TR state line 130 may control a bias modification transistor 106 by using a control voltage signal, such as the TR control signal, to turn the bias modification transistor 106 on or off. The bias modification transistor 106 may be an FET, and may also be the switch transistor 102, although the present invention is not limited thereto. By sending a control voltage signal to turn on the FET 106, the gate signal line 131 is electrically coupled to ground 132. This in turn grounds out the gate of the of the gate transistor 101 of the amplifier 30, 40 shown in FIG. 3. In embodiments of the present invention, for the TR state line 130 to go high, the drain voltage 111 at the output side 31/41 of the amplifier 30/40 must be approximately 0 volts. Accordingly, by manipulating the bias voltage of the bias transistor 106, the impedance of the amplifier 30, 40, may be controlled, and the amplifier 30, 40 may be operated as a switch.

Accordingly, benefit may be realized where an amplifier in an electrical system is operated as a switch. Although operation of an amplifier 30, 40 according to embodiments of the present invention is depicted in conjunction with a TR system 10, operation of an amplifier 30, 40 according to other embodiments may apply to other situations wherein a path through the amplifier is to be opened and closed. For example, embodiments of the present invention may be applied to a single amplifier whose output is employed as a signal switch in the absence of an antenna or other components of a TR system, such as a system processor. Furthermore, embodiments of the present invention may be applied to an antenna system lacking bidirectional capability (e.g., operating in either a receive mode or a transmit mode), wherein an output of an amplifier is employed as a signal switch in a signal path (e.g., transmit or receive) of the antenna system.

While the present invention has been particularly shown and described with reference to exemplary embodiments thereof, it will be understood by those of ordinary skill in the art that features of different embodiments may be combined to form further embodiments, and that various changes in form and details may be made therein, without departing from the spirit and scope of the present invention as defined by the following claims and their equivalents.

## Claims

1. A method of employing an amplifier output of an amplifier as a signal switch, the method comprising:
coupling a gate of a switch transistor of the amplifier to a switch signal line;
coupling a gate of an amplifier transistor of the amplifier to a gate signal line; and
controlling impedance of the amplifier by manipulating gate bias voltages of the transistors via the signal lines.

2. The method of claim 1, wherein controlling impedance of the amplifier comprises enabling an electrical signal to pass through the amplifier in an on mode, and preventing an electrical signal from passing through the amplifier in an off mode.

3. The method of claim 1 further comprising coupling the signal lines to a system processor and coupling a drain of the amplifier transistor to the system processor, wherein manipulating gate bias voltages of the transistors comprises delivering a control signal to the switch signal line and manipulating a drain voltage of the drain.

4. The method of claim 1 further comprising operating tuning elements of the amplifier as one or more quarter-wave shunt switches.

5. The method of claim 1, wherein controlling impedance of the amplifier comprises operating tuning elements of the amplifier.

6. The method of claim 1 further comprising coupling the gate signal line to an electrode of the switch transistor, wherein manipulating gate bias voltages of the transistors comprises delivering a control signal to the switch signal line and manipulating a drain voltage of the amplifier transistor.

7. The method of claim 1 further comprising coupling the gate signal line to an electrode of the switch transistor, wherein delivering a control signal to the switch signal line couples the gate signal line to a ground.

8. The method of claim 1, wherein the amplifier is a transmit amplifier, the switch transistor is a transmit switch transistor, the amplifier transistor is a transmit amplifier transistor, the switch signal line is a transmit switch signal line, and the gate signal line is a transmit gate signal line, the method further comprising:
coupling a gate of a receive switch transistor of a receive amplifier to a receive switch signal line;
coupling a gate of a receive amplifier transistor of the receive amplifier to a receive gate signal line;
coupling the output of the receive amplifier to a system processor;
coupling an input of the transmit amplifier to the output of the receive amplifier;
coupling an input of the receive amplifier to an antenna;
coupling the output of the transmit amplifier to the input of the receive amplifier;
coupling the switch signal lines to the system processor; and
controlling impedances of the amplifiers by manipulating gate bias voltages of the transistors via the signal lines.

9. The method of claim 8, wherein coupling the output of the transmit amplifier to the input of the receive amplifier comprises directly coupling the output of the transmit amplifier to the input of the receive amplifier.

10. The method of claim 8, wherein coupling an input of the transmit amplifier to the output of the receive amplifier comprises directly coupling an input of the transmit amplifier to the output of the receive amplifier.

11. The method of claim 8 further comprising coupling the receive gate signal line to an electrode of the receive switch transistor, and coupling the transmit gate signal line to an electrode of the transmit switch transistor.

12. The method of claims 8 or 11, wherein manipulating gate bias voltages of the transistors comprises delivering TR control signals from the system processor to the switch signal lines.

13. The method of claim 8 further comprising coupling the gate signal lines to the system processor and coupling drains of the amplifier transistors to the system processor, wherein manipulating gate bias voltages of the transistors comprises manipulating drain voltages of the amplifier transistors.

14. The method of claim 8 further comprising:
operating the receive amplifier with nominal impedance and the transmit amplifier as an open-circuit during a receive mode;
detecting a receive signal with the antenna; and
delivering the receive signal detected by the antenna to the system processor during the receive mode.

15. The method of claim 14 further comprising:
operating the receive amplifier as an open-circuit and the transmit amplifier with nominal impedance during a transmit mode;
delivering a transmit signal to the antenna from the system processor during the transmit mode; and
radiating the transmit signal delivered to the antenna.
